(19) **Europäisches Patentamt**

**European Patent Office**

**Office européen des brevets**

(11) **EP 1 069 200 A1**

(12) **EUROPEAN PATENT APPLICATION**
published in accordance with Art. 158(3) EPC

(43) Date of publication:
17.01.2001 Bulletin 2001/03

(51) Int. Cl.⁷: **C22C 38/00**, C21D 6/00, B22D 11/01

(21) Application number: 99909327.1

(22) Date of filing: 24.03.1999

(86) International application number:
PCT/JP99/01470

(87) International publication number:
WO 99/49092 (30.09.1999 Gazette 1999/39)

(84) Designated Contracting States:
DE GB

(30) Priority: 25.03.1998 JP 9829798

(71) Applicant:
KANTO SPECIAL STEEL WORKS LTD.
Fujisawa-shi, Kanagawa 253-0035 (JP)

(72) Inventors:
• FURUYA, Yasubumi
Sendai-shi, Miyagi 989-3205 (JP)

• WATANABE, Tadao
Natori-shi, Miyagi 981-1245 (JP)
• AIBA, Mituru,
Kanto Special Steel Works Ltd.
Fujisawa-shi, Kanagawa 253-0035 (JP)

(74) Representative:
Wagner, Karl H., Dipl.-Ing. et al
Wagner & Geyer,
Patentanwälte,
Gewürzmühlstrasse 5
80538 München (DE)

(54) **IRON-BASED MAGNETIC SHAPE MEMORY ALLOY AND METHOD OF PREPARING THE SAME**

(57) A magnetic shape memory alloy was developed which undergoes a magnetically induced martensitic phase transformation on application of an external magnetic energy and which actualizes a giant magnetostriction from an iron-based magnetic shape memory alloy such as an iron-palladium alloy containing 27-32 atomic % of palladium and an iron-platinum alloy containing 23-30 atomic % of platinum, said alloy having high crystal anisotropy and low energy grain boundaries at high frequencies, and undergoing a martensitic twin phase transformation.

External stress (τ)    External magnetic field (H)    Magnetic moment(M)

τ → New twin boundary

H̄

Adjacent variants having twin boundaries in different directions

Old twin boundary

H̄

Magnetostriction actualized in conventional magnetic material (Rotation and motion of domain (Moment))
↓   ↓   ↓
"Supermagnetostrictive material"

(a) Shape memory alloy Stress-induced martensitic Transformation
↓   ↓   ↓
Superelastic effect (large strain generated and recovery)

(b) Magnetic shape memory alloy Magnetically-induced martensitic transformation
↓   ↓   ↓
Giant magnetostriction (This invention)

Figure 1

EP 1 069 200 A1

## Description

### TECHNICAL FIELD

The present invention relates to a magnetic shape memory alloy which undergoes a magnetically induced martensite phase transformation upon application of an external magnetic energy thereto and can exhibit a giant magnetostriction; and to a process for manufacturing said alloy.

### BACKGROUND OF TECHNONOGY

Functional materials that can generate displacement (strain) and force (stress) as materials that can be incorporated into mechanical structures are called solid actuators; and the materials include piezoelectric materials, magnetostriction materials, shape memory materials, electrorheological fluids and the like. For the generation of actuator functions, every case requires a phase transformation phenomenon in the crystal structure, and the accompanying physicochemical quantities (parameters) and mechanodynamic energy conversion.

Magnetostrictive materials that have conventionally been used included elemental metals such as Ni, Co, and the like, Fe-Al alloys, and ferrites; but from the beginning of the 1980s, rare earth alloys called super magnetostrictive materials appeared which had an order of magnitude greater magnetostriction constant than has been conventionally available. For such rare earth alloys, a variety of alloys are known which include Tb-Fe, Te-Ni-Fe, Te-Co-Fe, Dy-Fe, Pr-Co, and the like; typical alloys Tb0.27-0.3Dy0.7-0.73Fe1.0-2 exhibit a saturation magnetic strain from 1500-2000ppm.

Shape memory alloys provide considerable deformation (strain) amounting to several percent (5-8%). These shape memory effects are generated as a rearrangement motion of atomic groups (shear type twins) that accompanies a thermoelastic martensitic phase transformation under stress.

However, in order to generate a shape memory phenomenon with a change in temperature, it becomes necessary to thermally control the heating and cooling. In this case, in particular, a slow response during cooling where heat dissipation from the sample is rate-determining, presents problems in that even with a thin strip, this is at most about 5-10Hz, which is detrimental to a repetitious operation, a stumbling block to development of a practical operation.

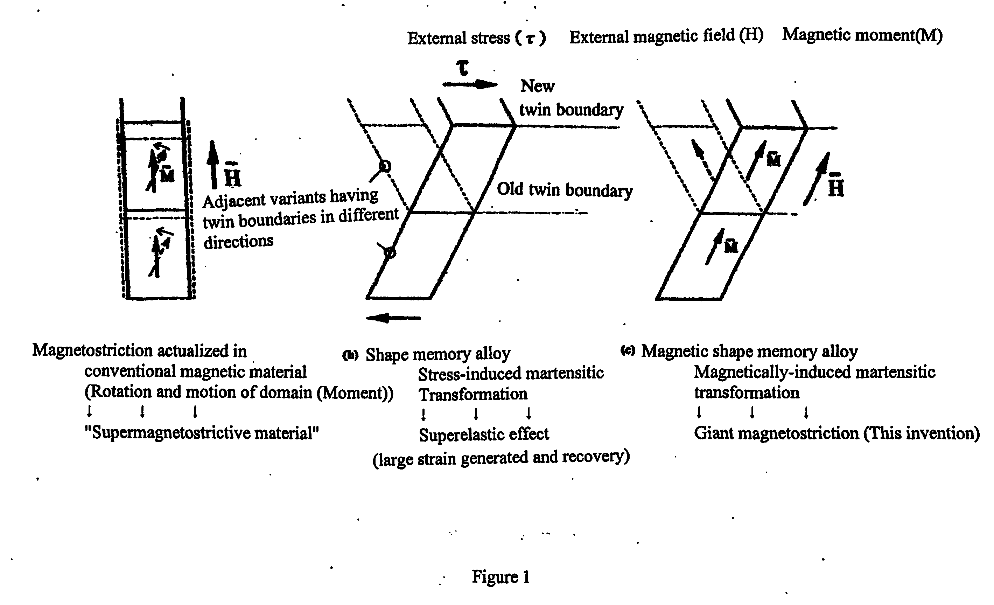

In response to the above problems, attempts have recently been made to achieve a large magnetostriction and a high speed response by controlling, not thermally, but magnetically, the shape memory phase transformation phenomenon. In the United States, Russia, and Northern European countries, searches have begun for shape memory alloys possessing magnetic functions. This search involves an experimentation to induce, displace, and furthermore rearrange the martensitic transformation (twinning transformation), which causes a shape memory effect upon application of an external magnetic energy. The mechanism for the magnetostriction is illustrated in Figure 1 in comparison with the conventional magnetostriction mechanism for a ferromagnetic material generated from a magnetic domain displacement and the rotation of its internal magnetic moment.

$Ni_2MnO_3$ was reported in 1997 and drew attention as a shape memory alloy that can offer a high speed operation where the crystal structure changes due to a magnetic field or an electrical field (*Kogyo Zairyo (Industrial Materials)*, November, 1997, pp 108-111). The present inventors' research (Matsumoto, Furuya, and Masumoto: *Nihon Kinzoku Gakkai-Ho*, Volume 32, No.7 pp 505-507) gave results also indicating that the shape memory effect is strongly affected by the crystal anisotropy of the material and that a TiNiCu type shape memory alloy, obtained as fine columnar crystals by means of a liquid rapid cooling/solidification, affords a large transformation strain.

### DISCLOSURE OF THE INVENTION

Problems To Be Solved By The Invention

If it were possible to magnetically control a shape memory phase transformation phenomenon, it would become possible, on application of an external magnetic field, to generate a strain which is an order of magnitude greater than that generated under the conventional magnetostriction mechanism, due to the magnetic domain rotation and to achieve a response which is much faster (~ 20kHz) than that obtained by the thermal method, whereby the slow response problem of the thermally controlled shape memory alloys, which has heretofore been a bottleneck, could be overcome. Development of such a magnetically responsive giant magnetostrictive shape memory alloy would be able to open up new fields in shape memory alloy type sensors and actuators and would be anticipated to find broad applications as multifunctional intelligent materials.

Means To Solve The Problem

In order to solve the foregoing problems, the present inventors used the electromagnetic float melt nozzle-less rapid solidification method (Japanese Patent Application H9-275268: Laid Open H11-90584), that had previously been invented by one of the present inventors to generate rapidly cooled thin strips for which crystal orientations and their boundary structures were designed and controlled so as to study their shape memory characteristics and magnetostriction characteristics. Using the above method, iron based shape memory alloys, particularly a Fe-Pd alloy, and a Fe-Pt alloy, were studied in which the melt was rapidly solidified and rolled between rapid solidification rotating rolls to control the structure, which led to a discovery that an alloy exhibiting a giant magnetostriction phenomenon can be obtained by a specific structure that depends on the cooling speed conditions in the rapid solidification and the annealing conditions for the rapidly solidified material.

Accordingly, the present invention provides an iron-based magnetic shape memory alloy which comprises an alloy generated by solidifying the melt, followed by rolling and working, wherein said alloy has a high crystal anisotropy, wherein low energy grain boundaries are formed at high frequencies, and wherein a martensitic twin phase transformation is induced by an applied magnetic field. A heat treatment for recrystallization after strong working gives an iron based magnetic shape memory alloy having high crystal anisotropy. In addition, rapidly solidifying the melt generates an iron based magnetic shape memory alloy wherein said alloy has high degree of crystal anisotropy, low energy grain boundaries are generated at high frequencies, and random grain boundaries which are high energy grain boundaries are suppressed, and said alloy is susceptible to the induction of martensitic twinning transformation by an applied magnetic field.

This iron based magnetic shape memory alloy comprises an aggregate of columnar crystal grains with an as-rapidly-solidified average crystal grain size of not more than 10μm, preferably having a grain boundary character distribution as measured by a crystal orientation auto-analyzer [orientation imaging microscopy] to be Σ1:10% or more, Σ3-29:15% or more (these two are low energy grain boundaries), and random grain boundaries (high energy grain boundaries: not more than 75%.

The iron based magnetic shape memory alloy has a magnetostriction, that accompanies a magnetically induced phase transformation, of 300με or more at a saturation magnetic field level.

The suitable composition for the iron based magnetic shape memory alloy is an iron-palladium alloy with a palladium content of 27-32 atomic % or an iron-platinum alloy with a platinum content of 23-30 atomic %.

In the present invention, the suitable method for the foregoing solidification and rolling is a method comprising continuously feeding the metal melt to rapid solidification rolls and rapidly solidifying and rolling, thereby fabricating thin strips or fiber. This method comprises float-melting an alloy raw material using a first electromagnetic induction coil for melting the raw material mounted above the rolls, narrowing the melt flow falling dropwise from the melt mass into a fine, steady flow by a second electromagnetic induction coil situated beneath the electrical induction coil used for melting the raw material, and continuously feeding the flow between rapid solidification rolls without using a melt ejection nozzle.

In the above method, it is preferred to select the melt cooling speed so as to generate columnar crystals extending uniformly in the thickness direction of the rapidly solidified thin strip and comprising a metal structure having an aggregate of fine single crystal grains with high crystal orientation (anisotropy). In general, it will be effective to refine the rapidly solidified grain to be not more than about 10μm, preferably not more than 8μm so as to further improve the strength of the material base. Annealing the rapidly solidified material obtained by the above method for a short time will remove any microscopic internal strains introduced during the rapid solidification, will cause a certain amount of weak crystallization thereby reducing the amorphous or non-equilibrium unstable boundary phases and strengthening the crystal anisotropy (orientation), so as to further permit an improvement of not only magnetostrictive properties, but also of shape memory characteristics. In the case certain types of ferromagnetic shape memory alloys, under an applied external magnetic energy, due to that magnetic energy, martensitic twin (variant) boundaries can move in the external magnetic field direction and rearrange. In such a case, one can obtain a large strain which accompanies a large magnetically induced phase transformation type; this type of phenomenon can occur if the material has a magnetocrystalline anisotropy energy ($U_k$) which is equal to or greater than its twin boundary motion energy ($E_t$):

$$U_k \text{ (magnetocrystalline anisotropy energy)} > E_t \text{ (twin boundary motion energy)} + W$$

$$\text{(amount of work done by the material to the outside).}$$

Furthermore, magnetic anisotropy energy is intensified in the direction of magnetization along a specific crystal orientation so that the control of crystal orientation of a ferromagnetic material in a specific direction is important in material design for a magnetic shape memory alloy.

In general, for an iron based metal material, the relationship between crystal grain size (d) and the yield strength (Fy) is governed by the Hall-Petch law, $\sigma y \propto d^{-1/2}$; the smaller the crystal grain size, the greater the strength. Increased strength of the base material is preferred because it will be possible to prevent degradative factors such as irreversible compositional change including rearrangements introduced to the base, with respect to a repetitious shape memory effect or the exhibition of magnetostriction; thus, this will possibly promise improvement in functional properties. However, in an iron based material, a crystal grain size of about 10μm is the smallest level normally attained even after a conventional strong working and rolling followed by annealing for a short time. Therefore, in order to achieve a greater degree of fine crystal formation and thereby to improve material base strength, it is essential to use rapidly solidifying conditions of 1 x 10^2 to 1 x 10^6 K/sec which is only feasible with the use of the liquid rapid solidification method; in this case, the rapidly solidified material will have a crystal grain size of 10μm or less.

According to the process of this invention, the rapidly solidified material has a grain size, as-rapidly-solidified-and-rolled, of about 10μm or less. The faster the cooling rate, the finer the grain size; but it was discovered that shape memory characteristics and magnetostriction characteristics strongly depend upon the metal's crystal orientation and grain boundary character distribution. For example, products obtained at roll speeds of 28.3m/s and 37.7m/s, as rapidly solidified and as annealed, were found to show considerable differences in shape memory characteristics and magnetostriction characteristics. In general, products obtained by annealing for a short time gave better properties; this is due to the fact that the cooling speed and annealing conditions affect not only the crystal grain size, but also the aggregation of orientational distributions and the ratio of the presence of low energy grain boundaries. Even then, when comparing samples obtained at 900°C for 1 hour annealing (Example 2 and Comparative Example 1), Example 2 gives better properties. This may be rationalized in that Comparative Example 1 had a higher low-energy grain boundary ratio, but much less crystal anisotropy than did Example 2, causing the difference. Therefore, for high performance, it is most important to control crystal orientation distribution.

For example, it was found that in a material formed at a rapid solidification roll speed of 28.8m/sec, annealing it tended to cause the crystal grain boundary distribution to concentrate in the (100) direction with improvement in both shape memory characteristics and magnetostriction characteristics. In the case of a rapidly solidified material with a roll speed of 37.7m/sec, it had a high frequency of low energy grain boundaries, but its crystal orientation distribution was random causing a decrease in the two properties.

Therefore, it should be possible to obtain a high degree of magnetostriction if firstly, a brief annealing or the like is performed to accumulate the crystal grain orientation distribution; secondly, if it is processed to have a high frequency of low energy grain boundaries. As an example, for an Fe-29.6at%Pd alloy which was rapidly solidified at 28.3 m/sec, 900°C and annealed 1 hour, the martensite twin (variant) was activated with respect to motion, thereby achieving a large strain (about 2000με (ppm) level) that was brought about by the phase transformation of a magnetic induction type immediately below the inverse phase transformation temperature (As=436K=163°C )on application of an external magnetic field.

BRIEF EXPLANATION OF THE DRAWINGS

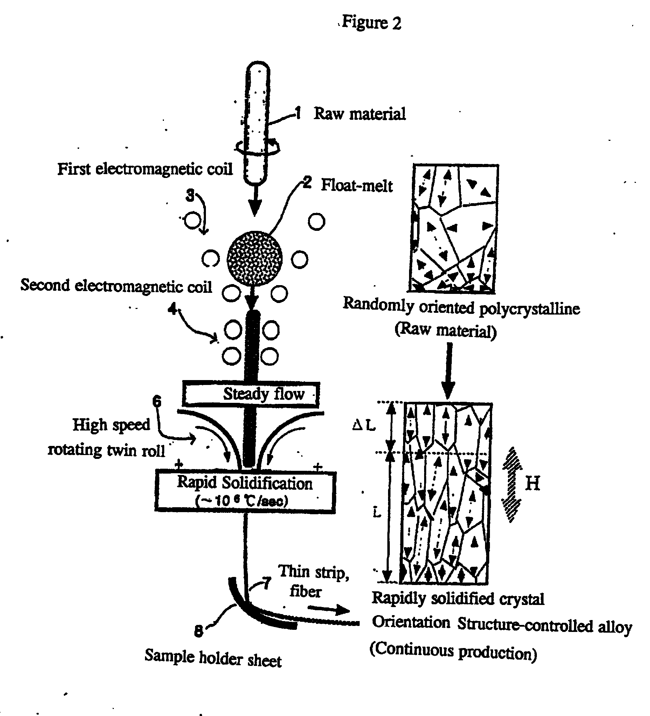

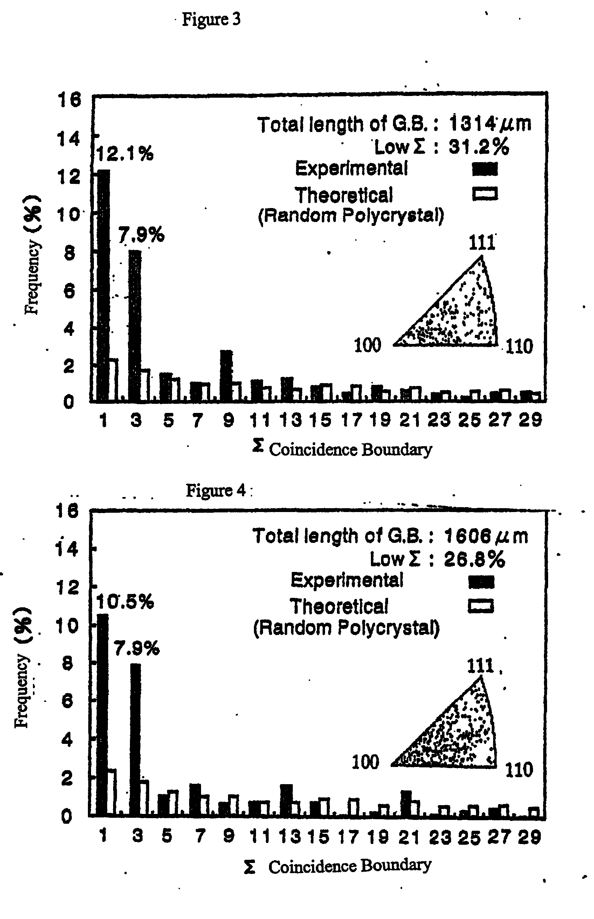

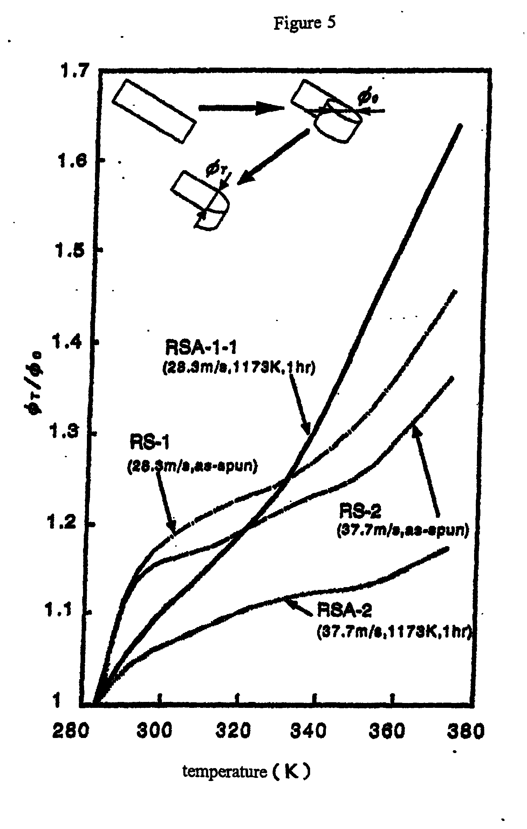

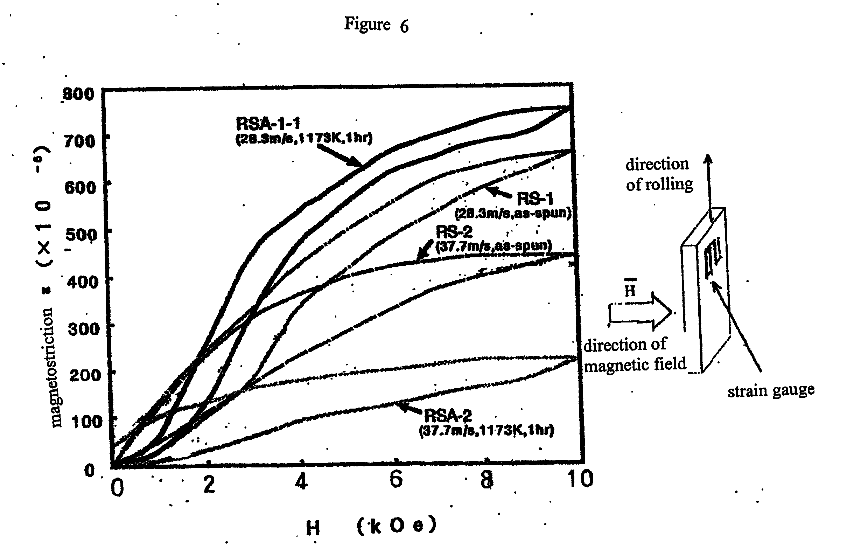

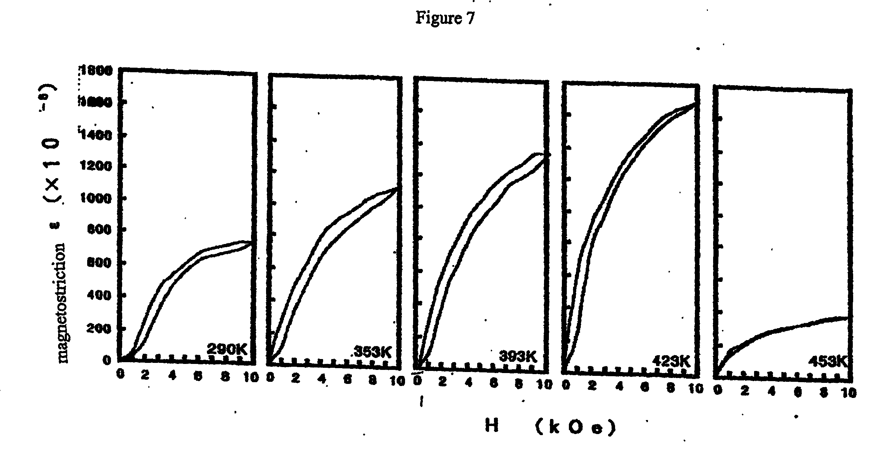

Figure 1 is a schematic drawing for a magnetostriction generation mechanism in a conventional ferromagnetic material accompanying the rotation of the magnetic domains and magnetic moments and for a giant magnetostriction generation mechanism in a magnetic shape memory alloy of this invention accompanying a magnetic field induction type rearrangement of martensitic twins (variant). Figure 2 is a schematic drawing illustrating the electromagnetic field control nozzle-less liquid rapid solidification device used by the process of this invention and a solidified metal structure. Figure 3 is a graph showing the results of analyzing the grain boundary character distribution of Example 1 according to OIM. Figure 4 is a graph showing the results of the grain boundary character distribution of Example 2 according to OIM. Figure 5 is a graph showing the shape recovery-temperature curves of Examples and Comparative examples. Figure 6 is a graph showing the results of measuring magnetostriction of Examples and comparative examples. Figure 7 is a graph showing the results of measurement of change in magnetostriction below and above the inverse phase transformation temperature (As=163°C) in Example 2 which showed the largest strain.

BEST MODE OF THE INVENTION

"The electromagnetic float-melting and nozzle-less rapid solidification method" used in the process of this invention is a method comprising continuously feeding the metal melt of an electrically conducting material such as metals, ceramics, etc. to rapid solidification rolls and rapidly solidifying and thereby fabricating thin strips or fiber, further comprising float-melting a raw material using a first electromagnetic induction coil for melting the raw material mounted above the rolls, narrowing the melt flow falling dropwise from the melt mass by a second electromagnetic induction coil situated beneath the electrical induction coil for melting the raw material into a fine, steady flow, and continuously feeding the flow onto rapid solidification rolls without using a melt ejection nozzle.

This method is explained using a schematic drawing of Figure 2. To illustrate by means of schematic drawing of Figure 2. Raw material 1 which is a randomly oriented polycrystalline material that is continuously fed from above the first high frequency electromagnetic coil 3 located above the high speed rotation rolls 6 for rapid solidification such as single rolls and twin rolls and the like, is electromagnetically float-melted in a high frequency electromagnetic coil 3, thereby generating a float-melted melt pool 2. The electrical magnetic coil 3 is wound spirally in an inverse cone shape structure with a larger inside diameter for the upper and a smaller inside diameter for the lower part thereof. Underneath of said magnetic coil 3 is located a smaller inside diameter second high frequency electromagnetic coil 4 for narrowing the melt flow. From above the first electromagnetic field coil, material (raw material) can be steadily fed, and the electrical magnetic power of the second high frequency connecting coil squeezes the dripping melt flow, thereby adjusting the melt dripping rate to give a steady flow, which is a flow whose flow condition remains unchanged with time.

When an electrical current is passed through electromagnetic coil 3, and raw material (solid) 1 is fed from the above to the electromagnetic coil 3 then the Lorentz force (magnetic flux direction, B) generated by the current passing through the electromagnetic coil 3 exerts an electromagnetic floatation force W upward for the metal raw material 1 in the electromagnetic coil 3, which along with the high frequency electromagnetic induction heating (Eddy current), holds the raw material 1 as heated and melted and floating in the middle of the electromagnetic coil 3 as a melt mass 2, which is stirred further by the eddy currents so as to be made homogeneous and highly purified. As the amount of melt raw material 1 is gradually increased, the weight of the floating melt pool 2 exceeds the electromagnetic floating force W so that as it relates to the surface tension or viscosity of the melt itself, it ends up dripping downward beneath the electromagnetic coil 3; the melt dripping downward is further squeezed into a fine flow by the second high frequency electromagnetic coil provided beneath the electromagnetic coil 3, resulting in a long steady flow 5 which flows downward to a designated section of the rapid solidification rotating rolls 6. The rapidly solidified thin band or thin wire 7 is received by material holder sheet 8 to travel in the transverse direction.

The melt which flows downward is rapidly solidified on the rapid solidification rotation rolls for controlling its structure so as to achieve higher material performance and higher functionalization. The schematic drawing at the right side of the Figure 2 depicts the way the randomly oriented polycrystalline material is rapidly solidified into an anisotropic structure-controlled alloy. In Figure 2, H indicates the magnetic field or the heat; L the original length, $\Delta L$ elongation after transformation or the strain (magnetostriction and the shape memory change). According to this method, a thin strip of 40-300$\mu$m thick or a fiber about 30-200$\mu$m in diameter can be fabricated.

EMBODIMENTS

Examples of this invention and comparative examples are explained below.

Examples 1-3

Electrolytic iron and 99.9% pure Pd were mixed according to the designated alloy concentration ratio and arc melted to give an Fe-29.8at%Pd alloy button ingot. Part of the ingot was cut out and processed by the application of the electromagnetic rotation melt nozzle-less rapidly solidifying method in an argon atmosphere along with twin rolls at varied solidification speeds (the roll speed) to generate thin strips 60-90$\mu$m thick and 15mm wide. Table 1 shows preparative conditions for these samples. Part of a piece of the thin strip obtained was vacuum sealed in glass shield ($10^{-3}$Pa) and thus sealed in vacuo, was annealed at 1173K in an electrical furnace, followed by rapidly cooling in ice water thereby carrying out a linear shape memory heat treatment.

Each sample was electrolytically polished in a mixed acid of acetic acid: perchloric acid: methanol = 9:1:1 for a scanning electron microscope observation.

《Crystal Orientation Analysis and Determination of Boundary Character》

Electro-backscatter patterns (EBSP) obtained for individual grains contained in a sample that were measured using a crystal orientation auto-analyzer (Orientation Imaging Microscopy: OIM) based on the Electro-backscatter pattern method were detected with a CCD camera and computer processed for determining crystal orientation. A boundary character was determined from the relative orientation relationship with the adjacent crystal grain(s) and further, boundary character distributions were determined in a polycrystalline material.

The SEM-EBSP online crystal orientation, grain boundary character auto- analyzer consisted of an FE-SEM by Hitachi Seisakusho, OIM hardware and software by TSL, and a computer by SGI Company. The sample was held tilted at an angle of 70° with respect to the SEM electron beam to monitor a diffraction on a fluorescent screen in the vicinity of the sample. The diffraction pattern was then recorded as an image by a low light source high sensitivity television camera, followed by image processing and forwarding to the computer. The incorporated diffraction pattern was processed by the computer to index the crystal orientation. Data on the orientation obtained from the diffraction pattern and relative coordinates of the electron beams and sample surface were inputted to the computer. In this way a crystal orientation analysis was conducted at a given measurement point.

〈Shape Memory Test〉

Samples obtained as rapidly solidified and samples after linear memory heat treatment were used to fabricate test pieces 4mm in diameter. The course of transformation that took place when these samples were heated from room temperature (To=283K) to T=373K was continuously recorded using an 8mm video camera. The change in diameter ($\varnothing$T) of a sample which was measured from the recorded data, which was compared to the diameter ($\varnothing$To) at temperature 283K, with the ratio (=$\varnothing$T/$\varnothing$To) used to evaluate the shape memory recovery ratio.

〈Measurement of Magnetostriction〉

Magnetostriction was measured using a strain gauge attached to the sample surface in a magnetic field up to ±10kOe in the atmosphere at room temperature (290K). A thermocouple was attached near where the strain gauge was attached. A magnetic field was directed in a direction perpendicular to the sample surface (sheet thickness direction); the magnetostriction was measured in the sample's longitudinal direction. The magnetic field generator was a model made by Tohoku Special Steel Company. It was used under conditions of a 40mm magnetic field-gap to generate a magnetic field of 10kOe at 40V-25A. The voltage supplied was from a primary side constant voltage device and the controlled constant current was supplied from a low current device, at a level set by computer control.

Since it was necessary to make a measurement of magnetostriction at each temperature before and after the phase transformation temperature accompanied by generation, motion, and elimination of martensitic twins of Fe-Pd alloys that exhibit shape memory (recovery), a sample was held in a glass tube ($\varnothing$=40mm) wrapped with a strip heater for measuring magnetostriction under a constant temperature control. The strip sample was chucked with a gripping jig (made of brass) to securely hold both ends while the magnetic field was directed perpendicular to the sample surface (sheet thickness direction), whereby the magnetostriction in the sample's longitudinal direction was measured using a uniaxial strain gauge.

Table 1

| | Example 1 | Example 2 | Example 3 | Comp.Ex.4 |
|---|---|---|---|---|
| Roll Speed | 28.3m/g | 28.3m/g | 37.7m/g | 37.7m/g |
| Annealing Temperature | | 1137K | | 1173K |
| Annealing Time | | 1h | | 1h |
| No. of Crystal Grains | 238 | 407 | 172 | 216 |
| Average Grain Size (μm) | 2.9 | 2.8 | 2.9 | 4.7 |
| Grain Boundary Character | | | | |
| Distribution (Theoretical values) | | | | |
| Σ1%(2.3) | | | | |
| Σ3-29% (11.6) | 12.1 | 10.5 | 14.2 | 5.5 |
| Random % (86.1) | 19.8 | 16.9 | 22.6 | 38.9 |
| | 68.1 | 73.2 | 55.6 | 63.2 |

Table 1 and Figures 3 and 4 show the analytical results of the grain boundary character distribution with OIM. Figure 5 shows a shape recovery ratio-temperature curve of alloys of Examples and comparative examples. Figure 6 shows the results of measured magnetostriction of alloys of Examples and of Comparative examples. Figure 7 shows the result of measuring the change in magnetostriction below and above the inverse phase transformation temperature (As=163°C) of the Example 2 alloy, which exhibited a maximum strain.

The foregoing results show that the rapidly solidified material has a fine crystal grain size of about 3μm with considerable presence of the lower energy grain boundaries. In regard to Example 1 and Example 3 for as-rapidly-solidified samples, Example 3 with a faster cooling rate gave a finer product. In Example 2 prepared at a roll speed at 28.3m/s, the annealing caused aggregation of crystal grains in the (100) direction, but in Comparative Example 1 at a roll speed of 37.7m/s, the crystal grain distribution was random.

Figure 5 shows that the higher the frequency of low energy grain boundaries, the better the shape memory recovery. In a comparison of Examples 1 and 3 as rapidly solidified with Example 2 the annealing indicates that the recovery over 283K to 323K was better for the as-rapidly-solidified; beyond 348K, the annealed material showed better recovery, perhaps because the annealing may change the transformation temperature and actualize crystal anisotropy.

Figure 6 shows that Example 1 as rapidly solidified and Example 2 as annealed indicated that at room temperature, a high magnetostriction level of 650-750$\mu\epsilon$ was observed at 10kOe. Conceivably, this is due to high crystal anisotropy and low energy boundaries at high frequencies. However a drop in magnetostriction was seen in Comparative Example 1, an annealing material with $\Sigma$3 grain boundaries at high frequencies (twin, variants) introduced therein. It may be argued that in this material, crystal anisotropy hardly developed and that the mechanism of actualizing magnetostriction that involves the motion of the magnetic domains during the magnetization or domain rotation over the high magnetic field side was not yet activated at room temperature and hindered due to the introduction of low mobility twins.

Figure 7 shows magnetostriction hysteresis curves over 0~+10kOe for Example 2 under a stress load =+1MPa from room temperature to 453K (180°C), which gave the largest magnetostriction among the current runs. The slight stress load was applied in consideration of some likely stress in an actual magnetostriction actuator operation and was also intended to activate the boundary motion of the variants by promoting martensitic twin formation. The inverse phase transformation temperature (As) for this test example was As=433K (160°C), according to differential scanning calorimetry (DSC). With an increase in temperature, the magnetic strain increased to reach a large magnetostriction of 1750 microstrain (ppm) at 423K (150°C). Then at 453K (180°C), the strain rapidly dropped reverting to the usual Fe type rapidly solidified thin strip level strain(200-300 microstrain (ppm)).

The rise in the initial magnetic field in the magnetostriction curves immediately below (423K=150°C) the inverse phase transformation temperature (As) was very high reaching 900-1000 microstrain (ppm) at an external magnetic field strength H=+2kOe, which has reached the highest level among the previously known Fe based magnetostrictive material.

It is known that replacement of Pt with Pd, which is in the same Group VIII of the Periodic table provides a similar iron based magnetic shape memory alloy (see, for example, D.P. Dunne and C.M. Wayman, Metallurgical Transactions, Vol.4(1973), 137-145).

In particular, iron alloys containing 20-30 atomic % of platinum (Pt), are in an alloy system which gives a large magnetic-field-induced magnetostriction similar to the Fe-Pd alloy system, in that they have martensite onset temperatures (Ms) and inverse phase transformation onset temperatures (As) which are very similar to those of the Fe-Pd alloys, and that a large shape recovery phenomenon is observed accompanies the motion of martensitic twins (variant).

Table 2

| | Alloy Component (at%) | Fe-Pt System | | Fe-Pd | System |
|---|---|---|---|---|---|
| | | Ms(K) | As(K) | Ms(K) | As(K) |
| 1 | 20 | | | | |
| 2 | 22 | 182 | 214 | | |
| 3 | 24 | 214 | 254 | | |
| 4 | 26 | 245 | 289 | 230 | 262 |
| 5 | 28 | 302 | 401 | 253 | 304 |
| 6 | 30 | 264 | 315 | 330 | 420 |
| 7 | 32 | 210 | 263 | 210 | 263 |
| 8 | 34 | | | 123 | 180 |
| 9 | 36 | | | | |

Potential Industrial Utility

The present invention is an iron based alloy among iron based shape memory alloys, that can undergo a magnetic induction type martensite transformation upon application of an external magnetic energy in a manner similar to the conventional thermoelastic type which changes its shape on heating. Differing from the mechanism for the magnetostriction (deformation) due to the domain motion and rotation during the course of magnetization of many conventional magnetostrictive material, this novel material exhibits a large magnetostriction due to the motion and rearrangement of martensite twins (variant) induced by an applied external magnetic field, making it possible to take advantage of this material as a magnetic actuator (supermagnetostriction) element. This invention opens up the possibility of actualizing a giant magnetostriction which is at least one order of magnitude larger (10 times) than that conventionally available and will enable one to develop an actuator that can respond much faster (~20kHz) than is possible with the thermally controlled shape memory alloys; and thus offers a magnetic shape memory alloy as a new material to areas such as high performance magnetic sensors and magnetic actuators and the like, thereby bringing about substantial technical innovation as materials for application in precision protective sensors, machine parts, various actuators for micro-machines, robotic joint drives, high frequency oscillators, sonar, and the like.

**Claims**

1. An iron based magnetic shape memory alloy made by rolling and/or working solidified melt, comprising:

    high crystal anisotropy;
    high frequency of low energy grain boundaries; and
    a martensitic twin phase transformation induced by a magnetic field.

2. An iron based magnetic shape memory alloy as set forth in Claim 1, wherein said alloy has high crystal anisotropy made by a heat treatment for recrystallization after strong mechanical working.

3. An iron based magnetic shape memory alloy as set forth in Claim 1, wherein said alloy has high crystal anisotropy and high frequency low energy grain boundaries made by rapid solidification of the melt.

4. An iron based magnetic shape memory alloy as set forth in Claim 1, wherein said alloy comprises:

    an aggregate of columnar crystal grains having an average crystal grain size of not more than 10 $\mu$m as rapidly solidified and has a grain boundary character distribution, according to a crystal orientation auto-analyzer [Orientation Imaging Microscopy], of $\Sigma$1: 10% or higher, $\Sigma$3 -29: 15% or greater (the preceding two being low energy grain boundaries) and random grain boundaries (high energy grain boundaries): 75% or less.

5. An iron based magnetic shape memory alloy as set forth in Claim 1, wherein the magnetostriction due to magnetically induced phase transformation is 300$\mu\varepsilon$ (strain) or greater up to the saturation magnetic field strength for the material.

6. An iron based magnetic shape memory alloy as set forth in Claim 1, wherein the alloy is an iron-palladium alloy containing 27-32 atomic % of palladium.

7. An iron based magnetic shape memory alloy as set forth in Claim 1, wherein the alloy is an iron-platinum alloy containing 23-30 atomic % of platinum.

8. A process for manufacturing an iron based magnetic shape memory alloy as set forth in Claims 1-7, which comprises continuously feeding the metal melt to rapid solidification rolls for rapidly solidifying to generate a thin strip or fiber, further comprising

    float-melting using a first electromagnetic induction coil for melting the raw material mounted above the rolls, squeezing the melt dripping from the melt pool by a second electromagnetic induction coil located below the electromagnetic induction coil for melting the raw material into a fine steady stream, and
    continuously feeding the melt to rapid solidification rolls without using a melt ejection nozzle.

9. A process for manufacturing an iron based magnetic shape memory alloy as set forth in Claims 1-7, further comprising annealing the rapidly solidified material obtained by the process as set forth in Claim 8.

External stress ( $\tau$ )   External magnetic field (H)   Magnetic moment(M)

$\tau$

New twin boundary

Old twin boundary

Adjacent variants having twin boundaries in different directions

Magnetostriction actualized in conventional magnetic material (Rotation and motion of domain (Moment))

↓   ↓   ↓

"Supermagnetostrictive material"

(b) Shape memory alloy
Stress-induced martensitic Transformation

↓   ↓   ↓

Superelastic effect
(large strain generated and recovery)

(c) Magnetic shape memory alloy
Magnetically-induced martensitic transformation

↓   ↓   ↓

Giant magnetostriction (This invention)

Figure 1

EP 1 069 200 A1

.Figure 2

1 Raw material

First electromagnetic coil

3

2 Float-melt

Second electromagnetic coil

4

Randomly oriented polycrystalline
(Raw material)

Steady flow

6

High speed
rotating twin roll

Rapid Solidification
$(\sim 10^{6} \, °C/sec)$

$\Delta L$

L

H

Thin strip,
fiber
7

8

Sample holder sheet

Rapidly solidified crystal
Orientation Structure-controlled alloy
(Continuous production)

Figure 3

Figure 4 :

Figure 5

Figure 6

EP 1 069 200 A1

Figure 7

EP 1 069 200 A1

# INTERNATIONAL SEARCH REPORT

| International application No. |
|---|
| PCT/JP99/01470 |

**A. CLASSIFICATION OF SUBJECT MATTER**
Int.Cl⁶ C22C38/00, C21D6/00, B22D11/01

According to International Patent Classification (IPC) or to both national classification and IPC

**B. FIELDS SEARCHED**

Minimum documentation searched (classification system followed by classification symbols)
Int.Cl⁶ C22C38/00-38/60, C21D6/00, B22D11/01

Documentation searched other than minimum documentation to the extent that such documents are included in the fields searched

| | | | |
|---|---|---|---|
| Jitsuyo Shinan Koho | 1926-1996 | Toroku Jitsuyo Shinan Koho | 1994-1999 |
| Kokai Jitsuyo Shinan Koho | 1971-1999 | Jitsuyo Shinan Toroku Koho | 1996-1999 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP, 62-170453, A (Tanaka Kikinzoku Kogyo K.K.), 27 July, 1987 (27. 07. 87) (Family: none) | 1 |
| X | JP, 63-171824, A (Tanaka Kikinzoku Kogyo K.K.), 15 July, 1988 (15. 07. 88) (Family: none) | 1 |
| EX | JP, 11-90584, A (Japan Science and Technology Corp.), 6 April, 1999 (06. 04. 99) (Family: none) | 1-6, 8, 9 |
| PX | Yasufumi Furuya, "Denji fuyuu nozzle less kyuurei gyokohou de kaihatsushita atarashii keijou kioku goukin", Nihon Kikai Gakkai Dai 76 Ki Zenkoku Taikai Kouen Rombunshuu, 25 September, 1998, Vol. 76, No. 1, p.227-228 | 1-6, 8, 9 |
| EA | JP, 10-259438, A (Tokin Corp.), 29 September, 1998 (29. 09. 98) & EP, 866142, A1 & CN, 1193662, A | 1-9 |

| ☒ Further documents are listed in the continuation of Box C. | ☐ See patent family annex. |
|---|---|

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 9 June, 1999 (09. 06. 99) | 22 June, 1999 (22. 06. 99) |

| Name and mailing address of the ISA/ Japanese Patent Office | Authorized officer |
|---|---|
| | |
| Facsimile No. | Telephone No. |

Form PCT/ISA/210 (second sheet) (July 1992)

INTERNATIONAL SEARCH REPORT

International application No.

PCT/JP99/01470

C (Continuation). DOCUMENTS CONSIDERED TO BE RELEVANT

| Category* | Citation of document, with indication, where appropriate, of the relevant passages | Relevant to claim No. |
|---|---|---|
| A | Yasufumi Furuya, "Denji fuyuu youyu seigyo kyuurei gyouko process souchi no kaihatsu", Zairyou to Process, 5 September, 1997, Vol. 10, No. 6, p.831 | 1-9 |

Form PCT/ISA/210 (continuation of second sheet) (July 1992)